# EUROPÄISCHE PATENTANMELDUNG

(11) **EP 0 944 170 A2**
(43) Veröffentlichungstag der Anmeldung: **22.09.1999**
(21) Anmeldenummer: 99101197.4
(22) Anmeldetag: 22.01.1999
(51) Int. Cl.: H03K 5/1252

(54) **Filter für Pulssignale**

(30) Priorität: 20.03.1998 DE 19812420
(71) Anmelder: Moeller GmbH, 53115 Bonn (DE)
(72) Erfinder: Hubert, Rolf, 53229 Bonn (DE); Culca, Horea Stefan, 53721 Siegburg (DE); Bauerfeind, Dieter, 53177 Bonn (DE)

(57) **Zusammenfassung**

Verfahren zur Filterung verrauschter Spannungssignale, die als diskrete, insbesondere zwei logische Zustände repräsentierende Spannungslevel am Signaleingang eines elektronischen Schaltgerätes anliegen und dort in einem Lesevorgang auslesbar sind, wobei der Lesevorgang in mindestens zwei Leseschritte einteilbar ist und ein Schaltvorgang nach einer Bewertung der Leseergebnisse der erfolgten Leseschritte auslösbar ist.

## Beschreibung

Die Erfindung betrifft ein Verfahren zur Filterung verrauschter Spannungssignale, die als diskrete, insbesondere zwei logische Zustände repräsentierende Spannungslevel am Signaleingang eines elektronischen Schaltgerätes anliegen und dort in einem Lesevorgang auslesbar sind.

Bei der Verarbeitung digitaler Signale tritt bekanntermaßen das Problem auf, daß die sichere Identifikation der Signale durch das Rauschen auf den Spannungszuständen erschwert wird. Um trotz des hochfrequenten Rauschens ein Signal als solches identifizieren zu können ist es bekannt, den Strom mittels eines Kondensators über gewisse Zeit zu integrieren und das Ergebnis der Integration zu bewerten. Je länger dabei die Integrationszeit ist, desto genauere Ergebnisse liefert diese Art der Filterung.

Nachteilig an der bekannten Filterung ist, daß für längere Integrationszeiten größere Kapazitäten und damit größere und teurere Kondensatoren benötigt werden, was insbesondere bei kompakten elektronischen Kleingeräten, die billig produziert werden sollen, einen entsprechenden Nachteil mitsichbringt. Ebenso ist es nachteilig, daß die durch die Kondensatoren einmal festgelegten Bedingungen hinsichtlich der Güte der Filterung nur durch baulichem Aufwand an dem Gerät veränderbar sind. So ist es mit dieser Art der Filterung unmöglich, auf eine unterschiedliche Qualität der Signale durch Veränderung der Zeitkonstanten flexibel zu reagieren.

Aufgabe der Erfindung ist es daher, ein Verfahren zur Filterung verrauschter Spannungssignale zu schaffen, das die Signale zuverlässig identifiziert und das sich ohne großen Aufwand flexibel auf die Qualität der zu filternden Signale einstellen läßt.

Diese Aufgabe wird mit dem Verfahren zur Filterung verrauschter Spannungssignale nach Anspruch 1 gelöst.

Durch das erfindungsgemäße Verfahren ist eine vorteilhafte Möglichkeit zur Filterung hochfrequent verrauschter Signale gegeben. Das Verfahren ermöglicht eine bessere Filterung mit kürzereren Zeitkonstanten und eine flexible Anpassung an die zu erwartenden Signale. Besonders vorteilhaft läßt sich das Verfahren bei der Erkennung der Signale von Pulsfolgen einsetzen, bei denen die Signale die beiden Zustände "high" und "low" repräsentieren. Durch die Flexibilität kann die Entprellung auf die Charakteristik der Pulse eingestellt werden.

Erfindungsgemäß weist der Auslesevorgang mindestens zwei Leseschritte auf, wobei beim Lesen die Spannung am Signaleingang gemessen wird. Nach der eingestellten Zahl von Messungen (Leseschritten) wird die Gesamtzahl der Ergebnisse bewertet. Das Ergebnis der Bewertung bestimmt das Auslösen des Schaltvorganges. Vorteilhaft an dem erfindungsgemäßen Verfahren ist, daß weitgehend auf Hardwarefilter verzichtet werden kann.

Von besonderem Vorteil ist zudem, daß sich mit der Zahl der Leseschritte die Charakteristik des Filters und damit die Güte der Entprellung per Software einstellen läßt und daß auf aufwendige Hardwarekomponenten verzichtet werden kann. Damit erlaubt das Verfahren eine kostengünstige und zuverlässige Filterung und ist wegen des geringen baulichen Aufwandes für den Einsatz in elektronischen Kleingeräten, beispielsweise in Kleinsteuerungen besonders attraktiv. Es ist besonders vorteilhaft, das Verfahren zur Filterung der Eingangssignale in speicherprogrammierbaren Steuerungen einzusetzen, da diese eine Recheneinheit aufweist, welche die Koordination der Filterung bewerkstelligen kann. Wegen der sowies vorhandenen Recheneinheit bedarf es keines zusätzlichen Bauaufwandes.

Mit der erfindungsgemäßen Filterung läßt sich jedes damit ausgestattete Gerät nach Belieben auf die zu erwartende Güte der Eingangssignale einstellen. Dazu wird durch Festlegung der Anzahl der Leseschritte die Entprellung der einlaufenden Signale optimiert. Da für gering verrauschte Signalen lediglich eine geringe Anzahl von Leseschritten eingestellt werden muß, trägt das Verfahren zur Ersparnis von Verarbeitungszeit bei. In einer vorteilhaften Ausführungsform des Verfahrens ist es zur Optimierung der Meßergebnisse möglich, die Zeit der Wiederkehr zwischen zwei aufeinanderfolgenden Leseschritten zu verändern. So kann die Charakteristik der Messung auf das Frequenzverhalten der Signale weiter optimiert werden.

Bei einer vorteilhaften Ausgestaltung des Verfahrens werden die Leseergebnisse durch Setzen einer Triggerschwelle in zwei Zustände eingeteilt. Signale, die die Triggerschwelle überschreiten werden beispielsweise als "high" Zustände gewertet. Die Bewertung der Leseergebnisse kann nach der Überzahl der gemessenen Zustände geschehen. Der Schaltvorgang wird dann ausgelöst, wenn die Mehrzahl der Leseergebnisse den Zustand "high" ergeben hat. Diese Methode der hardwarmäßigen Bewertung hat den Vorteil, daß eine Umsetzung der analogen Signale in digitale vom Rechner zu bewertende Größen unnötig ist und so aufwendige Bauteile wie Analog-Digital-Konverter (ADC) eingespart werden können. Bei dem Verfahren kann es vorteilhaft sein, Vorfilter in Form kleiner Kapazitäten einzusetzen, um eine gewisse Vorauswahl der Eingangssignale zu treffen.

Um sämtliche Signale mit der darin enthaltenen Information für den Rechner nutzbar zu machen ist es vorteilhaft, die analogen Spannungen durch einen ADC in digitale Werte umzurechnen und in der Recheneinheit zu speichern. Die so gewonnen Werte können mit beliebigen statistischen Verfahren ausgewertet werden. Dieses Verfahren bietet den Vorteil, daß die Zuverlässigkeit der Entprellung durch Veränderung der Programmparameter und der statistischen Modelle einstellbar ist. Gleichzeitig kann jedoch auf einfache Weise aus den Ergebnissen ein Mittelwert gebildet werden, der bei Übertreffen eines durch die Software festgelegten Wertes (Triggerschwelle) den Schaltvorgang auslöst.

Das erfindungsgemäße Verfahren wird vorteilhafterweise in speicherprogrammierbaren Steuerung eingesetzt. Die Steuerungen fassen in einem Gehäuse eine Recheneinheit, einen Bildschirm, eine Bedieneinheit und Signalein- und -ausgänge zusammen. Derartige Steuerungen schalten in Abhängigkeit der an den Signaleingängen anliegenden Signale Ausgangsspannungen nach einem implementierbaren Schaltprogramm auf die Signalausgänge. Die Steuerungen werden für vielfältige Zwecke in Wissenschaft, Industrie und Haushalt eingesetzt und können aufgrund implementierter Programme eine Vielzahl unterschiedlicher Schaltfunktionen erfüllen. Die Qualität der Steuerung hängt davon ab, inwieweit die Eingangssignale sicher identifiziert werden.

Diese Art der Steuerungen bieten sich somit für den Einsatz des Verfahrens an, da entsprechende Recheneinheiten vorhanden sind. Auch ohne implementierte Recheneinheiten läßt sich das Verfahren durch in einer einfachen Steuerung durch Counter / Timer Module durchführen. Die Bewertung der Leseergebnisse wird in diesem Fall durch eine hardwaremäßig gesetzte Triggerschwelle geschehen. In besonders vorteilhaften Ausführungen der Steuerung ist der Signaleingang zusätzlich mit einem Frequenzfilter versehen, um eine schnelle Vorfilterung der Signale zu erreichen.

Gerade bei speicherprogrammierbaren Steuerungen wirken sich die Vorteile des Verfahrens besonders aus. So lassen sich die Steuerungen auf beliebige Signalqualitäten einstellen. Dabei wird durch den Verzicht auf große Kapazitäten viele Kosten und Bauraum eingespart. Die Vorgabe der Auslesezyklen ist durch das Schaltprogramm, bzw. durch die programmierbaren Parameter der Steuerung einstellbar. So kann ein Leseschritt durch einen im Programmzyklus gesetzten Interrupt ausgelöst werden. Innerhalb eines Programmzyklus kann eine beliebige Anzahl von Interrupts mit einstellbaren Wiederholungszeiten engesetzt werden. Dabei werden die Signale umso besser entprellt, je größer die Zahl der Auslesezyklen ist.

Das erfindungsgemäße Verfahren und die Steuerung sind in den Zeichnungen 1 und 2 dargestellt und werden im folgenden näher beschrieben. Es zeigen
- **Figur 1**: ein verrauschtes Signal und die Systematik des Entprellens und
- **Figur 2**: eine speicherprogrammierbare Steuerung.

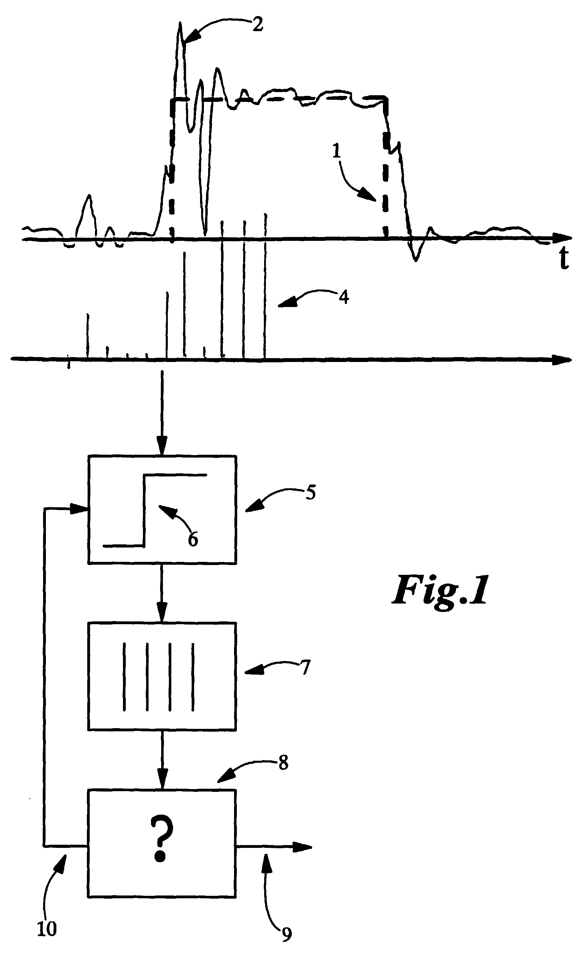

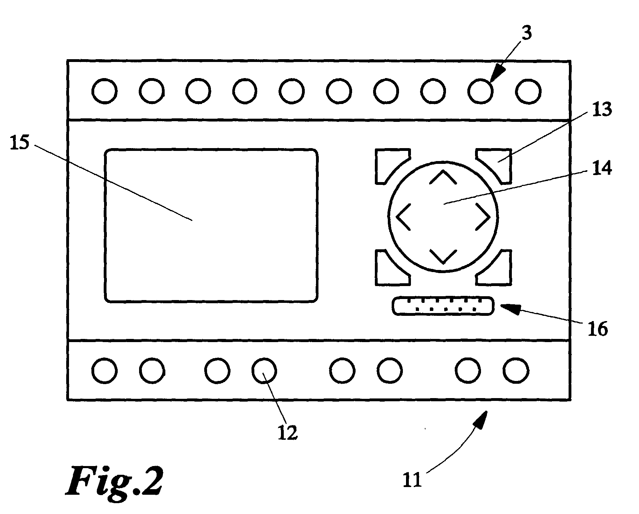

In Figur 1 sind ein idealisierter 1 und ein realer 2 Spannungsverlauf eines als Spannungspuls ausgebildeten Signales in Abhängigkeit von der Zeit dargestellt. Deutlich zu erkennen sind die Spitzen auf dem Spannungsverlauf, insbesondere die Überschwinger bei Änderung des Spannungslevels von "low" nach "high" und von "high" nach "low". Der dargestellte Puls liegt an einem Signaleingang 3 der in Figur 2 dargestellten Steuerung an. Die Steuerung ist so programmiert, daß sie nach kurzen Zeit-Intervallen Dt von beispielsweise ca. 10 ms die Spannung am Signaleingang abliest. Die Spannungswerte 4 werden in ein Schwellenmodul 5 eingebracht, das die Werte 4 mit einer Triggerschwelle 6 vergleicht und das die Signale, welche die Schwelle 6 übertreffen, einem Sammelmodul 7 zuführt.

In diesem Falle haben bisher vier der Signale die durch die Schwelle 6 gesetzte Bedingung erfüllt. Ob diese Zahl ausreichend ist, um den Puls zu akzeptieren und einen Schaltvorgang zu initiieren bestimmt ein Bewertungsmodul 8. Das Bewertungsmodul 8 initiiert den Schaltvorgang 9 oder ordnet einen weiteren Sammelvorgang 10 an. In diesem Ausführungsbeispiel sind die Module mit elektronischen Bauteilen wie Transistoren, Verstärkern, Counter- und Timermodulen realisiert. Eine Realisierung durch ein Programm ist jedoch ebenso denkbar.

Figur 2 zeigt eine speicherprogrammierbare Steuerung mit einem Gehäuse 11 und mit einer Reihe von Spannungs Eingängen 3 und Signalausgängen 12. Die Steuerung schaltet unter Kontrolle eines Schaltprogrammes den Stromfluß zwischen den Eingängen 3 und den Ausgängen 12. Das Programm kann der im Gehäuse 11 untergebrachten Recheneinheit einerseits mittels der Bedientasten 13 und der Mehrfunktionstaste 14 eingegeben werden, wobei die Eingabe und der Programmablauf auf dem Bildschirm 15 beobachtbar sind. Um die Programmierung zu erleichtern, ist auf dem Bildschirm 15 eine menuegeführte Benutzeroberfläche dargestellt. Es ist auch möglich, die Steuerung von einem externen Rechner zu programmieren. Dazu ist der Rechner mit der mechanischen Schnittstelle 16 über eine Datenleitung mit der Steuerung verbunden.

## Patentansprüche

1. Verfahren zur Filterung verrauschter Spannungssignale (2), die als diskrete, insbesondere zwei logische Zustände repräsentierende Spannungslevel am Signaleingang (3) eines elektronischen Schaltgerätes anliegen und dort in einem Lesevorgang auslesbar sind,
**dadurch gekennzeichnet,** daß der Lesevorgang in mindestens zwei Leseschritte einteilbar ist und ein Schaltvorgang nach einer Bewertung der Leseergebnisse der erfolgten Leseschritte auslösbar ist.

2. Verfahren nach Anspruch 1,
**dadurch gekennzeichnet,** daß die Leseergebnisse durch eine Triggerschwelle (6) in zwei Zustände eingeteilt werden und der Schaltvorgang bei Überzahl für den entsprechenden Zustand ausgelöst wird.

3. Verfahren nach Anspruch 1,
**dadurch gekennzeichnet,** daß die Leseergebnisse statistisch bewertet werden und der Schaltvorgang nach der Bewertung ausgelöst wird.

4. Verfahren nach Anspruch 3,
**dadurch gekennzeichnet,** daß ein Mittelwert der Leseergebnisse gebildet wird und bei Übertreffen einer Triggerschwelle durch den Mittelwert der Schaltvorgang ausgelöst wird.

5. Verfahren nach einem der vorherigen Ansprüche,
**dadurch gekennzeichnet,** daß entsprechend der Qualität des zu erwartenden Eingangssignales die Zahl der Leseschritte innerhalb des Lesevorganges verändert wird.

6. Verfahren nach einem der vorherigen Ansprüche,
**dadurch gekennzeichnet,** daß die Zeit der Wiederkehr zwischen zwei Leseschritten eingestellt wird

7. Speicherprogrammierbare Steuerung zur Durchführung des Verfahrens nach den Ansprüchen 1 bis 6,
**gekennzeichnet durch,**
- eine Recheneinheit, einen Bildschirm (15), eine Bedieneinheit (13,14) und durch Signaleingänge (3) und Signalausgänge (12),
- wobei die Recheneinheit, der Bildschirm (15), die Bedieneinheit (13,14) und die Signaleingänge (3) und Signalausgänge (12) in einem gemeinsamen Gehäuse (11) untergebracht sind
- wobei an einen Signaleingang (3) ein Eingangssignal (2) anlegbar ist, das den Ablauf eines Programmzyklus initiiert und die Ausgabe eines Wertes an einem Signalausgang (12) veranlaßt,
- wobei einen Signaleingang (3) mittels eines progammierbaren Lesevorganges auslesbar ist und
- wobei der Lesevorgang in mindestens zwei Leseschritte einteilbar ist und der Schaltvorgang nach einer Bewertung der Leseergebnisse der erfolgten Leseschritte auslösbar ist.

8. Steuerung nach Anspruch 7,
**dadurch gekennzeichnet,** daß der Signaleingang mit einem Frequenzfilter versehen ist.

9. Steuerung nach Anspruch 7 oder 8,
**dadurch gekennzeichnet,** daß ein Leseschritt durch einen im Programmzyklus setzbaren Interrupt auslöstbar ist.

10. Steuerung nach einem der Ansprüche 7 bis 9,
**dadurch gekennzeichnet,** daß in einem Programmzyklus eine beliebige Anzahl von Interrupts setbar ist.

11. Steuerung nach einem der Ansprüche 7 bis 10,
**dadurch gekennzeichnet,** daß der zeitliche Abstand der Interrupts einstellbar ist.
